# EUROPEAN PATENT SPECIFICATION

(11) **EP 1 938 937 B1**
(45) Date of publication and mention of the grant of the patent: **16.05.2012**
(21) Application number: 07124072.5
(22) Date of filing: 27.12.2007
(51) Int. Cl.: B29C 33/38, G03F 7/00, H01J 9/24, B29C 33/42

(54) **Method of manufacturing soft mold for shaping barrier rib, method of manufacturing barrier rib and lower panel, and plasma display panel**
Verfahren zur Herstellung einer weichen Form zum Formen einer Rippe, Verfahren zur Herstellung einer Rippe und Unterplatte sowie Plasmaanzeigetafel
Procédé de fabrication de moule souple pour mettre en forme une nervure de barrière, procédé de fabrication d'une nervure de barrière et panneau inférieur, et panneau d'affichage à plasma

(30) Priority: 29.12.2006 KR 20060138904; 31.05.2007 KR 20070053419
(43) Date of publication of application: 02.07.2008
(73) Proprietor: Samsung SDI Co., Ltd., Suwon-si Gyeonggi-do (KR)
(72) Inventor: Yang, Dong-Yol, Daejeon (KR); Ryu, Seung-Min, Daejeon 305-701 (KR); Park, Suk-Hee, Daejeon 305-701 (KR); Choi, Jong-Seo, Gyeonggi-do (KR); Choi, Kwi-Seok, Gyeonggi-do (KR); Lee, Beom-Wook, Gyeonggi-do (KR)
(74) Representative: Hengelhaupt, Jürgen

(56) References cited:
- EP-A- 1 431 018
- WO-A-98/57206
- WO-A-2004/064104
- WO-A-2005/013308
- US-A- 6 023 130

## Description

The present invention relates to a method of manufacturing a barrier rib included in a plasma display panel (PDP), and more particularly, to a method of manufacturing a soft mold and a method of manufacturing a barrier rib by preparing the soft mold.

In a plasma display panel (PDP), barrier ribs are interposed between an upper substrate and a lower substrate to partition a plurality of discharge spaces, and a plurality of sustain electrodes and address electrodes having predetermined patterns are formed across the discharge spaces to cause display discharge in the discharge spaces, thus creating ultraviolet rays which excite phosphor layers, thereby forming a predetermined image.

The barrier ribs prevent electrical and optical crosstalk between the discharge spaces, thereby improving display quality including color purity. Also, the barrier ribs provide an area on which fluorescent materials are coated, thereby providing the luminance of the PDP. In addition to the direct functions mentioned above, the barrier ribs partition the discharge spaces to define unit pixels formed by red (R), green (G), and blue (B) discharge spaces, and define a cell pitch between the discharge spaces to determine the resolution of an image. As described above, the barrier ribs are an essential component for improving image quality and luminous efficiency, and thus a variety of research has been conducted on barrier ribs due to the recent demand for large-area high-resolution panels.

WO 2005/013308 A1 discloses a method and master mold comprising a metal support layer and a fine structure pattern comprised of a glass or ceramic material, wherein the pattern support layer is formed of a first material having a relatively low grinding speed, and the fine structure pattern is formed of a layer of a second material having a grinding speed higher than that of the material of the pattern support layer. For forming a barrier rib structure, a flexible mold is formed by using UV curable material and a metal mold. A similar method is disclosed in WO 2004/064104 A1 dealing with a flexible mold for a back surface plate of a plasma display panel.

Conventionally, a barrier rib may be manufactured using a screen printing method, a sandblasting method, an etching method, or a photolithographic method using photosensitive paste. Screen printing is a simple, low-cost method, but a process of aligning a screen with a lower substrate and a process of printing and drying paste for a barrier rib should be repeated several times for each printing process. Also, when the screen is not precisely aligned with the substrate during a printing process, the barrier rib may be misaligned. Therefore, a barrier rib manufactured by screen printing may be formed with low precision and the top surface of the barrier rib may not be planar.

The sandblasting method is most widely used because it is advantageous for large-area panels. However, there is a specific technical limit in forming a high-resolution barrier rib using physical shock applied to etching particles due to highly pressured air. Also, when the dry film and the barrier rib paste layer are positionally deviated from each other during a lamination process of attaching dry film resist for an etch stop layer on a barrier rib paste layer, the resulting barrier rib may be misaligned. In addition, when the time taken to delaminate the dry film is extended, the barrier rib may be delaminated from a dielectric layer so that a barrier rib having a desired shape cannot be obtained.

The etching method includes attaching a material for a barrier rib to a substrate and etching the material for the barrier rib using an appropriate etchant. In the etching method, a barrier rib may be stably shaped, a closed-type high-resolution barrier rib may be formed, and the number of process operations can be reduced as compared with a conventional sandblasting method. Therefore, the etching method is sufficiently competitive in terms of quality and price. However, since the etching method involves mechanical and chemical etching processes, large amounts of materials may be lost, and environmental pollution may be caused. Above all, using the etching method, a barrier rib having a uniform shape cannot be formed for large-area PDPs, and only a small range of materials can be used as the etchable material for forming the barrier rib.

The photolithographic method using photosensitive paste may include: coating photosensitive paste containing a ceramic material for a barrier rib on a substrate; drying the photosensitive paste to a desired thickness; selectively exposing the photosensitive paste to light by aligning a mask; shaping a barrier rib by removing an exposed portion using a developing solution; and manufacturing a final barrier rib through a sintering process. The photolithographic method is simpler than the above-described etching method because a process of forming photoresist is omitted. However, shapes of barrier ribs formed using the photolithographic method vary according to exposure conditions. Specifically, when a thick photosensitive paste layer containing glass powder and ceramic powder is exposed to light, it is difficult to obtain a uniform photosensing result due to scattering of the glass and ceramic powder. Further, when manufacturing large-area panels using the photolithographic method, such as PDPs, maintaining exposure conditions uniform over a large area is difficult, photosensitive paste is expensive, and a substantial amount of material is removed, thereby producing a large quantity of industrial waste matter.

### SUMMARY OF THE INVENTION

The present invention provides a method of manufacturing a soft mold, which is accurately shaped and has highly stable dimensions in order to form a high-resolution barrier rib pattern.

Also, the present invention provides a method of manufacturing a barrier rib and a lower panel for a plasma display panel (PDP) using a molding process.

According to an aspect of the present invention, there is provided a method of manufacturing a soft mold. The method includes: providing a metal mold on which a barrier rib pattern is formed by alternating concave portions and convex portions; disposing a polymer sheet opposite the metal mold; transferring the barrier rib pattern of the metal mold by imprinting the metal mold into the surface of the polymer sheet under pressure such that the polymer sheet has a surface on which an inverted image of the barrier rib pattern is formed to form the soft mold; and releasing the soft mold from the metal mold.

The step of providing the metal mold may comprise forming a photoresist (PR) pattern having the shape of a barrier rib on a base substrate; forming a silicon mold having an inverted pattern conformable to the PR pattern; forming a metal seed layer required for electroplating along a surface of the pattern of the silicon mold; and filling the pattern of the silicon mold with an electroplating layer to form the metal mold on the metal seed layer. The silicon mold is then released from the metal old.

The step of forming the PR pattern may comprise the step of patterning a PR layer using exposure and developing processes.

The step of forming the silicon mold may comprise coating a silicon shaping material to bury the PR pattern, and curing the silicon shaping material so that the silicon mold to which the PR pattern is transferred is obtained.

According to another aspect of the present invention, there is provided a method of manufacturing a barrier rib for a PDP. The method includes: preparing a soft mold according to the above method of manufacturing a soft mold for shaping a barrier rib, the mold having a patterned surface; disposing a dielectric sheet opposite the mold; and transferring a pattern of the mold into the dielectric sheet under pressure to shape a patterned layer to which pressure is applied and an unpatterned layer disposed on the reverse side of the patterned layer.

The barrier rib pattern may comprise alternating concave portions and convex portions.

The unpatterned layer of the dielectric sheet may be formed to a sufficient thickness to fully incorporate or bury electrodes.

According to yet another aspect of the present invention, there is provided a method of manufacturing a lower panel of a PDP. The method includes: preparing a soft mold formed according to the above method of manufacturing a soft mold for shaping a barrier rib, the mold having a patterned surface; disposing a dielectric sheet opposite the mold; transferring a pattern of the mold onto the dielectric sheet under pressure to shape the dielectric sheet to have a patterned layer having a first thickness and an unpatterned layer having a second thickness; disposing the unpatterned layer of the dielectric sheet opposite a plurality of exposed electrodes of a substrate; and bonding the dielectric sheet to the substrate under pressure.

The barrier rib pattern may comprise alternating concave portions and convex portions.

The method may further comprise vertically aligning the mold bonded to the dielectric sheet with the electrodes of the substrate after disposing the unpatterned layer and before bonding the dielectric sheet to the substrate under pressure.

In the bonding of the dielectric sheet to the substrate under pressure, the unpatterned layer of the dielectric sheet may bury or fully incorporate or fully cover the electrodes of the substrate.

After the bonding of the dielectric sheet to the substrate under pressure, the method may further comprise the steps of releasing the soft mold, and sintering the dielectric sheet and the substrate that are bonded to each other.

### BRIEF DESCRIPTION OF THE DRAWINGS

The above and other features and advantages of the present invention will become more apparent by describing in detail exemplary embodiments thereof with reference to the attached drawings in which:

FIG. 1 is a process flowchart illustrating a method of manufacturing a soft mold, according to an embodiment of the present invention;

FIGS. 2A through 2D are cross-sectional views illustrating a method of forming a photoresist (PR) pattern, according to an embodiment of the present invention;

FIG. 3 is a photographic image of an example of a PR pattern formed using the method of FIGS. 2A through 2D;

FIGS. 4A through 4D are cross-sectional views illustrating a method of forming a silicon mold, according to an embodiment of the present invention;

FIG. 5 is a photographic image of an example of a mold pattern formed in a silicon mold manufactured using the method of FIGS. 4A through 4D;

FIGS. 6A through 6C are cross-sectional views illustrating a method of forming a metal mold, according to an embodiment of the present invention;

FIGS. 7A through 7D are cross-sectional views illustrating a method of forming a soft mold using a metal mold manufactured using the method of FIGS. 6A through 6D, according to an embodiment of the present invention;

FIG. 8A is a perspective view of an example of a soft mold manufactured using the method of FIGS. 7A through 7D, according to an embodiment of the present invention;

FIG. 8B is a partially cutaway perspective view taken along a line A-A' of FIG. 8A, according to an embodiment of the present invention;

FIG. 9 is a photographic image of a pattern of a soft mold similar to that illustrated in FIG. 8A;

FIGS. 10A through 10D are cross-sectional views illustrating a method of manufacturing a large-area soft mold, according to an embodiment of the present invention;

FIG. 11 is a process flowchart illustrating a method of manufacturing a lower panel for a plasma display panel (PDP), according to an embodiment of the present invention;

FIGS. 12A through 12F are cross-sectional views illustrating the method of FIG. 11, according to an embodiment of the present invention; and

FIG. 13 is an exploded perspective view of a PDP according to an embodiment of the present invention.

### DETAILED DESCRIPTION OF THE INVENTION

The present invention will now be described more fully hereinafter with reference to the accompanying drawings, in which exemplary embodiments of the invention are shown. The present invention is largely divided into a process of manufacturing a soft mold and a process of manufacturing a barrier rib for a plasma display panel (PDP) by preparing the soft mold.

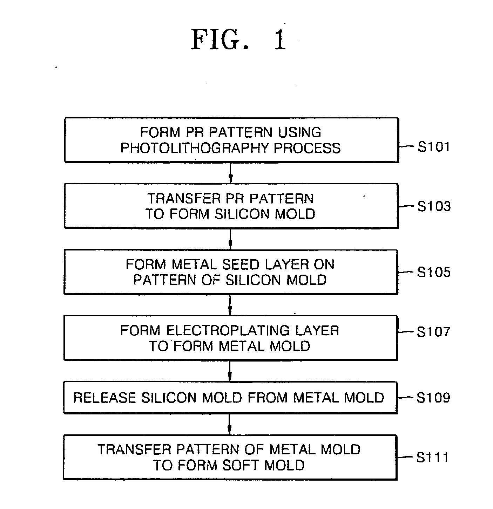

FIG. 1 is a process flowchart illustrating a method of manufacturing a soft mold, according to an embodiment of the present invention.

First, a photoresist (PR) pattern is formed on a substrate using a photolithography process in operation S101. A silicon mold is formed using the PR pattern as a mold and using silicon rubber as a material in operation S103. Thereafter, a metal seed layer required for an electroplating process is deposited on the silicon mold in operation S105. In operation S107, a metal mold is then manufactured by forming an electroplating layer on the silicon mold on which the metal seed layer is formed. Next, the metal mold is released from the silicon mold in operation S109. The metal mold is imprinted on a polymer sheet to obtain a soft mold in operation S111.

Hereinafter, operations S101 through S111 will be described in detail.

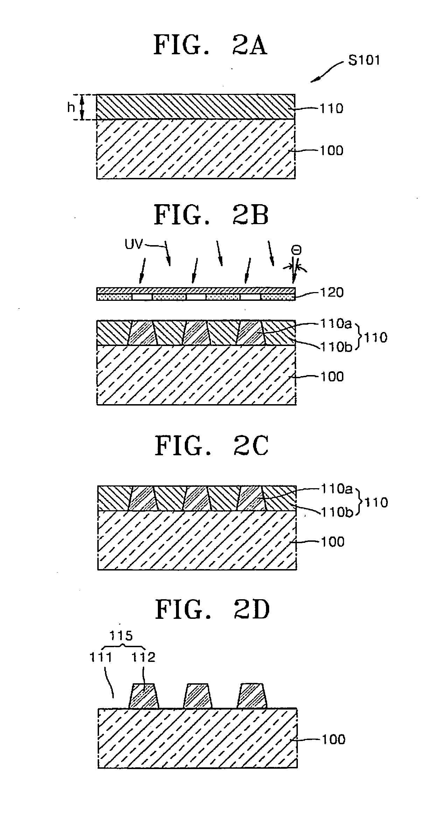

FIGS. 2A through 2D are cross-sectional views illustrating operation S101 of forming a barrier rib pattern on a base substrate 100 using a photolithography process, according to an embodiment of the present invention. To begin with, the base substrate 100 is prepared. The base substrate 100 may be a glass substrate, which has a low surface roughness and a uniform surface characteristic even if it has a large area. Referring to FIG. 2A, a PR layer 110 is formed on the base substrate 100. The PR layer 110 may be obtained by coating a photosensitive resin on the base substrate 100, whereby the photosensitive resin may react with irradiated light and be cured,. For example, the PR layer 110 may be a negative type dry film resist (DFR) layer. Since a coated height "h" of the PR layer 110 corresponds to the height of a finally obtained barrier rib, the height "h" may be controlled to be in the range of about 150 to 250 µm. In order to form the PR layer 110 to a predetermined height, a DFR laminated layer may be prepared by stacking a plurality of DFR thin layers.

Referring to FIG. 2B, after forming the PR layer 110 on the base substrate 100, a photo mask 120 is aligned in a predetermined position and irradiated with ultraviolet (UV) light. In this case, UV light may be irradiated not perpendicularly to a front surface of the photo mask 120 but at a predetermined inclination angle e to the photo mask 120. As a result, sides of patterns can be inclined as illustrated in FIG. 2D. In another inclined irradiation method, the base substrate 100 on which the PR layer 110 is coated may be inclined to a desired angle and irradiated with UV light. Referring to FIG. 2C, a portion 110a, which is selectively exposed by the photo mask 120, is cured due to a crosslinking reaction or a polymerization reaction, and an unexposed portion 110b which is not exposed to UV light remains uncured.

Referring to FIG. 2D, after irradiating UV light, a developing process is performed. During the developing process, the uncured portion 110b is removed to form a concave portion 111, while the cured portion 110a remains to form a convex portion 112.

In the present application, a convex portion 112 is a structure having a top surface parallel to the top surface of the underlying layer and being shorter than the bottom surface contacting the underlying layer, its cross-section thus having a trapezoidal structure. The side walls of the trapezoidal rib or convex portion 112 are sloped from the top of the convex portion 112 to the bottom of the convex portion 112. A corresponding concave portion 111 is defined by the gap between the convex portions 112.

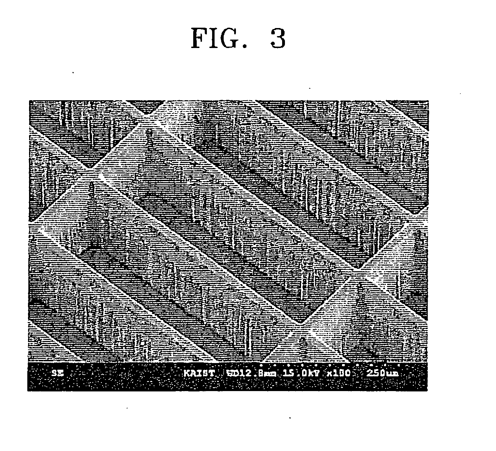

A PR pattern 115, which is formed by regularly alternating concave portions 111 and convex portions 112, corresponds to the finally obtained barrier rib. That is, the concave portion 111 corresponds to a discharge space in which plasma discharge occurs, and the convex portion 112 corresponds to a barrier rib that partitions the discharge spaces. FIG. 3 is a photographic image showing a PR barrier rib pattern obtained using the above-described process. Here, the PR barrier rib pattern may be formed as a matrix type barrier rib pattern and include barrier ribs intersecting with each other.

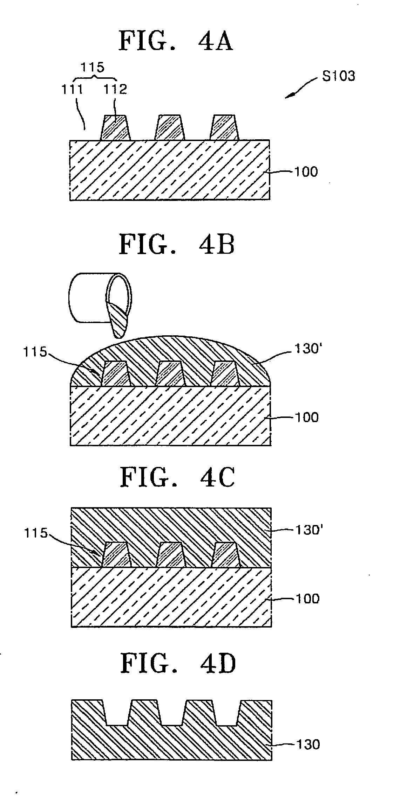

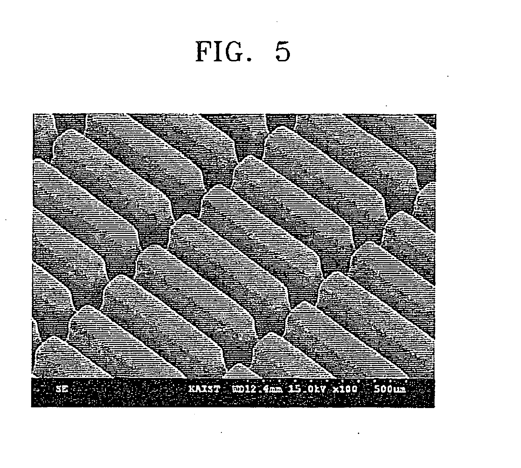

FIGS. 4A through 4D are cross-sectional views illustrating operation S103 of reproducing a pattern having an inverted image of the PR pattern 115 using the PR pattern 115 as a mold, according to an embodiment of the present invention. To begin with, referring to FIGS. 4A and 4B, a shaping material 130' is coated to a large thickness on an embossed PR pattern 115 to fill the PR pattern 115. The shaping material 130' contains silicon rubber and a hardening agent. The silicon rubber may be, for example, polydimethylsiloxane (PDMS) Sylgard 184A from Dow Corning Corp. The silicon rubber and the hardening agent may be mixed in a ratio of 10 to 1. When air bubbles are interposed between the shaping material 130' and the PR pattern 115 during the coating of the shaping material 130', the concave portions 111 may remain unfilled. In order to overcome this problem, the shaping material 130' may be coated in a vacuum chamber for excluding inflow of air. Referring to FIG. 4C, when the PR pattern 115 is completely filled with the shaping material 130', the resultant structure is cured at a predetermined temperature and the PR pattern 115 is released as shown in FIG. 4D. Since PDMS, which is the main component of the shaping material 130', has a smooth surface and low surface energy, it has excellent release characteristics. After releasing the PR pattern 115, a silicon mold 130, which is reproduced to have an inverted image of the PR pattern 115 and patterned in intaglio, is obtained. FIG. 5 is a photographic of an intaglio pattern similar to that of the silicon mold 130.

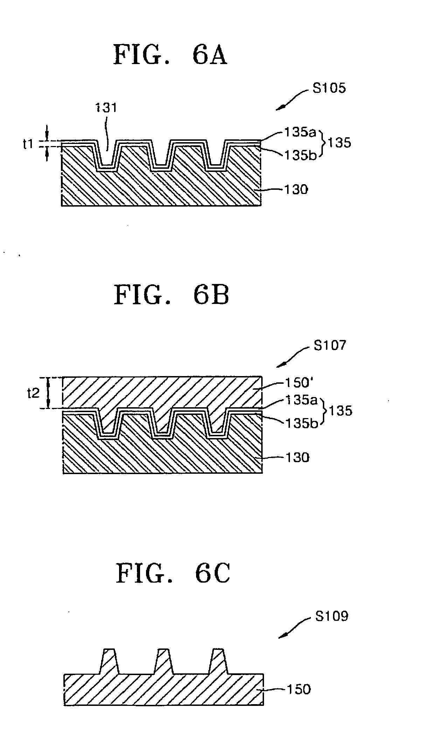

FIGS. 6A through 6C are cross-sectional views illustrating operations S105 to S109 of forming a metal mold 150 using the silicon mold 130, according to an embodiment of the present invention. To begin with, referring to FIG. 6A, a metal seed layer 135 is coated along the surface of the silicon mold 130. This is a preprocessing process for an electroplating process that will be performed using the metal seed layer 135 as one electrode and a plated material as the other electrode. Although gold (Au), which has high electric conductivity, may be considered as a material for the metal seed layer 135, since adhesion of Au with the silicon mold 130 is unreliable, a chrome (Cr) thin layer 135b is first deposited as a under layer, and an Au thin layer 135a is formed thereon. Since the metal seed layer 135 should have enough release to separate the metal mold 150, which will be formed by electroplating, from the silicon mold 130, it must have a sufficient thickness t1. For this, the Cr thin layer 135b may be formed to a thickness of about 1000 to 5000 Å, and the Au thin layer 135a may be formed to a thickness of about 1000 to 3000 Å. In the current embodiment, the Cr thin layer 135b and the Au thin layer 135a are taken only as examples of materials required for electroplating, and the metal seed layer 135 may be formed of various known materials. Referring to FIG. 6B, after forming the metal seed layer 135, an electroplating process is performed to form a metal plating layer 150'. In this case, nickel (Ni) may be used as a plated material. During the electroplating process, the density of the metal plating layer 150' depends on the current and voltage applied in the electroplating process. When the metal plating layer 150' is formed to a sufficient thickness t2 to fill and cover the concave portion 131 of the silicon mold 130, the electroplating process is finished. As a result, an embossed pattern matching the silicon mold 130 is formed on a surface of the metal plating layer 150'. Finally, referring to FIG. 6C, the silicon mold 130 is released to complete the metal mold 150.

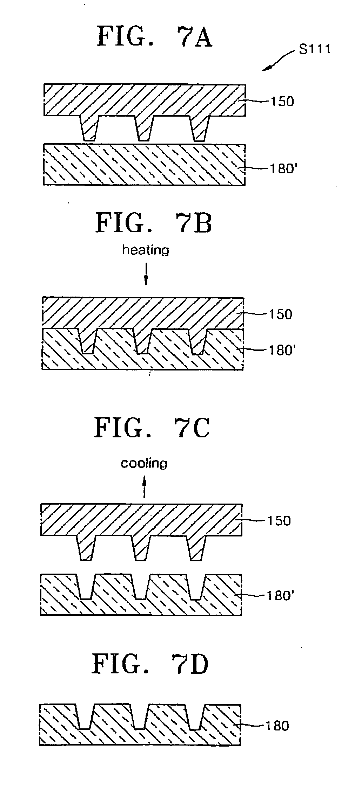

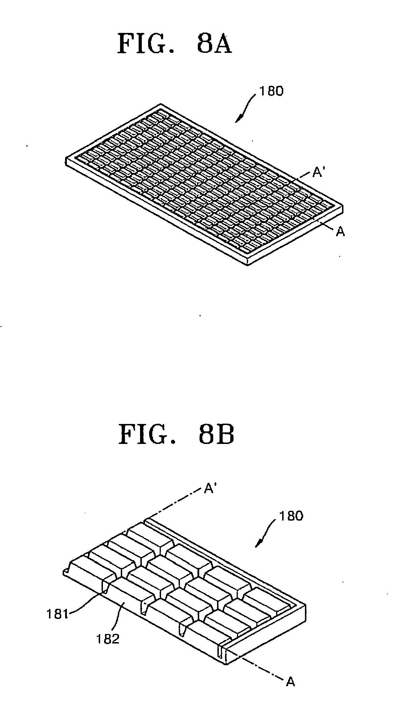

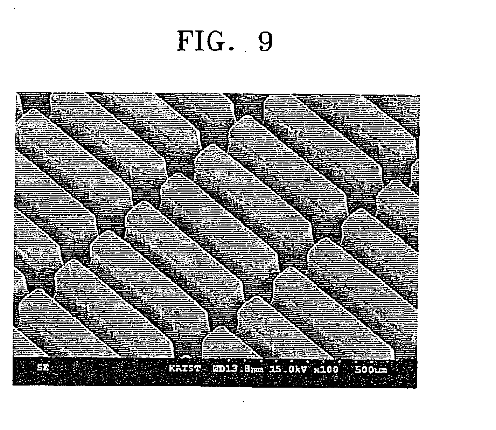

FIGS. 7A through 7D are cross-sectional views illustrating operation S111 of forming a soft mold 180 using the metal mold 150, according to an embodiment of the present invention. The process illustrated in FIGS. 7A through 7D, which will now be described in detail, is called a hot-embossing process. To begin with, referring to FIG. 7A, a polymer sheet 180' is disposed under the metal mold 150. The polymer sheet 18D' may be one of various engineering plastics, such as polycarbonate (PC), polymethyl methacrylate (PMMA), or polyethylene terephthalate (PT). Next, a pattern is transferred to the polymer sheet 180'. In this case, the transfer process is performed at a high temperature in order to sufficiently shape the polymer sheet 180'. In this case, a specific process temperature may be optimized considering a glass transition temperature of the polymer sheet 180'. Referring to FIG. 7B, the metal mold 150 is imprinted onto the underlying polymer sheet 180' under high temperature conditions to form a pattern having an inverted image to the pattern of the metal mold 15D. In this case, by applying a predetermined pressure to the metal mold 150 against the polymer sheet 180', an embossed pattern of the metal mold 150 is transferred to the polymer sheet 180' in intaglio. Referring to FIG. 7C, the resultant structure is cooled off to a normal temperature after a sufficient amount of time such that the pattern of the metal mold 150 is sufficiently transferred onto the polymer sheet 180'. Referring to FIG. 7D, the metal mold 150 is released, thereby completing the manufacture of the soft mold 180. FIG. 8A is a perspective view of the soft mold 180 manufactured using the above-described method, and FIG. 8B is a partially cutaway perspective view taken along a line A-A' of FIG. 8A, according to an embodiment of the present invention. Referring to FIGS. 8A and 8B, the soft mold 180 includes convex portions 182 and concave portions 181, which form a predetermined pattern on a surface thereof. The concave portion 182 is a portion where a discharge space will be formed by performing an imprinting process on a barrier rib material. The concave portion 181 is a portion where a barrier rib for partitioning discharge spaces will be formed by performing the imprinting process on the barrier rib material. FIG. 9 is a photographic image of a soft mold formed of PET, which is obtained using the method illustrated in FIGS. 8A and 8B.

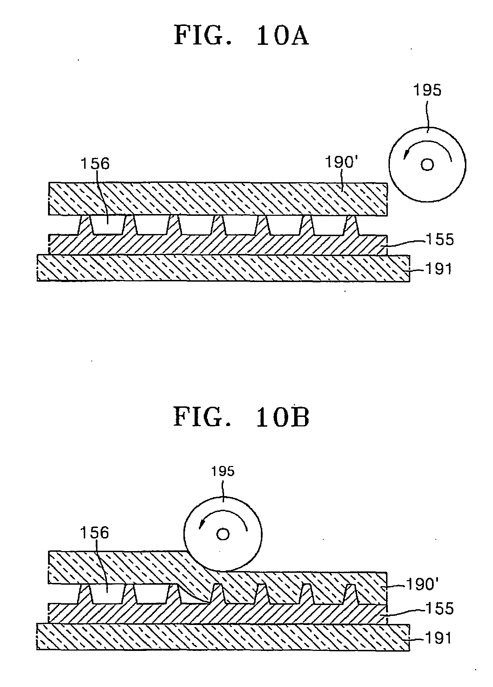

Meanwhile, although the method illustrated in FIGS. 7A through 7D is sufficient for manufacture of small and medium-sized soft molds less than 258 cm² (40 square inches) in area, it may be insufficient for manufacture of large-sized soft molds in excess of 40 square inches in area. For this reason, an additional process of manufacturing a large-area soft mold will now be described with reference to FIGS. 10A through 10D. Initially, referring to FIG. 10A, a metal mold 155, which is manufactured using the above-described process, is located on a base substrate 191. Thereafter, a release agent (not shown) is coated along a surface of the metal mold 155. A polymer sheet 190' is then disposed on the metal mold 155. Next, the pattern of the metal mold 155 is transferred to the polymer sheet 190'. In this case, the transfer process is performed at a high temperature in order to sufficiently pattern the polymer sheet 190'. In this case, a specific process temperature may be optimized considering a glass transition temperature of the polymer sheet 190'. Referring to FIG. 10B, a pressure roller 195 for applying a predetermined pressure is applied to the polymer sheet 190' at least once from one end of the polymer sheet 190' to the other end thereof, so that a concave portion 156 of the metal mold 155 is gradually filled with the polymer sheet 190', thereby marking the polymer sheet 190' with a pattern of the metal mold 155. In this case, an embossed pattern of the metal mold 155 is transferred to the polymer sheet 190` in intaglio. The pressure is applied by the pressure roller 195 until the top surface of the polymer sheet 190' is planarized, so that a uniform pattern is transferred to the entire surface of the polymer sheet 190'. Meanwhile, although the pressure roller 195, which rotates at uniform speed, is taken as an example of a pressure unit, the present invention is not limited thereto and any type of compressing member, which contacts the polymer sheet 190' and applies pressure thereto, may be used as the pressure unit.

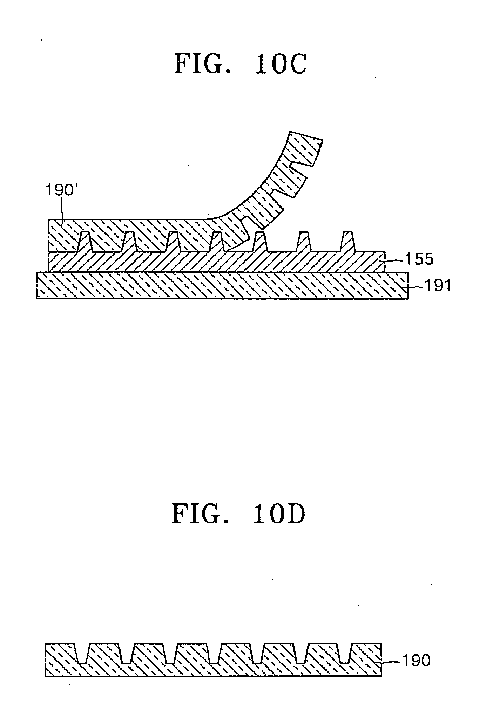

Thereafter, referring to FIGS. 10C and 10D, the polymer sheet 190' is released, and the metal mold 155 is removed to complete the manufacture of a large-area soft mold 190. In order to produce the soft mold 190 in large quantities, the polymer sheets 190' may be supplied one by one onto the metal mold 155. Alternatively, the polymer sheets 190' may be wound as a roll around a supply roller and cut one by one before and after a pattern transferring process.

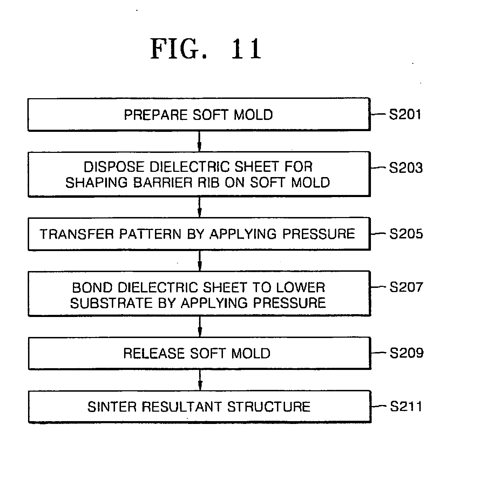

Hereinafter, a method of manufacturing a barrier rib for a plasma display panel (PDP) and a lower panel according to an embodiment of the present invention will be described. A process of manufacturing the barrier rib for the PDP will be described along with a process of manufacturing the lower panel since the two processes are performed consecutively. FIG. 11 is a process flowchart illustrating a method of manufacturing a lower panel for a plasma display panel (PDP), according to an embodiment of the present invention. Initially, a soft mold having a top surface on which concave portions and convex portions corresponding to the shape of a barrier rib are disposed is prepared in operation S201, and a release agent (not shown) is uniformly coated along the top surface of the soft mold. Thereafter, in operation S203, a dielectric sheet as a material for the barrier rib is disposed on the top surface of the soft mold on which the release agent is coated. Thereafter, a barrier rib pattern formed on the soft mold is transferred onto the dielectric sheet applying pressure, e.g by using a pressure roller in operation S205. The dielectric sheet having the barrier rib pattern is disposed opposite a lower substrate. In operation S207, the dielectric sheet is bonded under pressure to the lower substrate, here by using the pressure roller. In operation S209, the soft mold is released. In operation S211, the barrier rib pattern formed on the dielectric sheet is sintered, thereby completing the manufacture of the lower panel.

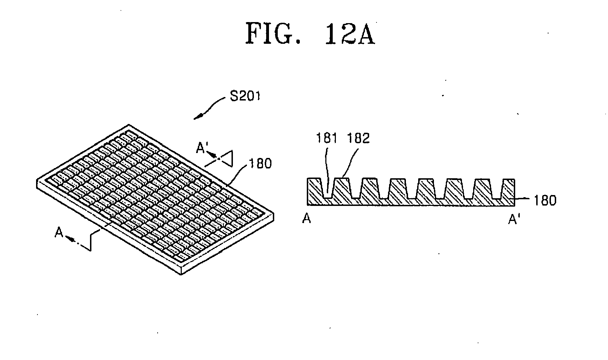

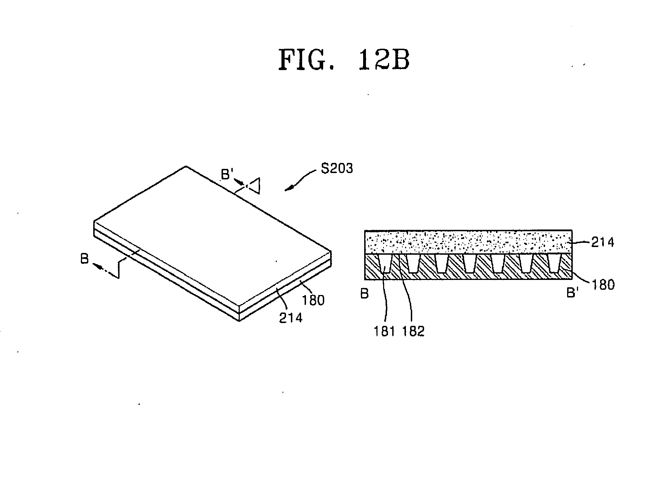

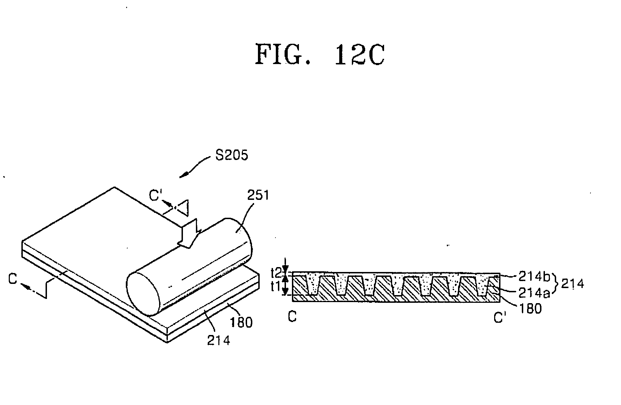

Hereinafter, operations S201 through S211 will be described in more detail with reference to FIGS. 12A through 12F. FIGS. 12A through 12F are cross-sectional views illustrating the method of FIG. 11, according to an embodiment of the present invention. Referring to FIG. 12A, a soft mold 180 having a top surface including a plurality of concave portions 181 and a plurality of convex portions 182 corresponding to the shape of a barrier rib is prepared. Referring to FIG. 12B, the surface of the soft mold 180 is processed with a release agent, and a dielectric sheet 214 as a material for the barrier rib is disposed on the soft mold 180. Referring to FIG. 12C, a pressure roller 251 is brought into contact with the dielectric sheet 214 under a predetermined pressure and moved from one end of the dielectric sheet 214 to the other end thereof at least once at a constant rotation rate, so that a pattern of the soft mold 180 is imprinted to the dielectric sheet 214. In this case, the concave portions 181 of the soft mold 180 are forcibly filled with the dielectric sheet 214, and thus the dielectric sheet 214 is shaped to have a patterned layer 214a having a first thickness t1 and an unpatterned layer 214b having a second thickness t2 due to the soft mold 180. The shaped dielectric sheet 214 may constitute a dielectric barrier rib. That is, the patterned layer 214a of the shaped dielectric sheet 214 may function as a barrier rib for partitioning discharge spaces of a PDP, and the unpatterned layer 214b of the shaped dielectric sheet 214 may function as a dielectric layer in which electrodes of the PDP are buried. Accordingly, the first thickness t1 of the patterned layer 214a is related to the dimension of the discharge spaces, and the second thickness t2 of the unpatterned layer 214b is related to the burying of the electrodes. Thus, it may be necessary to control the depth of the concave portions 181 of the soft mold 180 or the entire thickness of the dielectric sheet 214. Meanwhile, in the method illustrated in FIG. 12C, since pressure is applied until the top surface of the dielectric sheet 214 is planarized, a uniform pattern can be formed throughout the dielectric sheet 214.

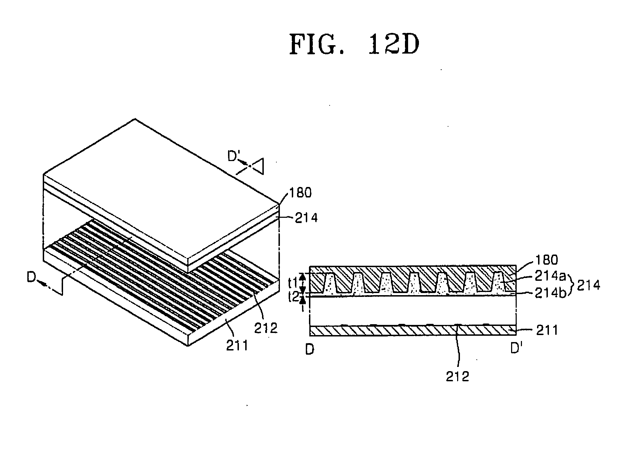

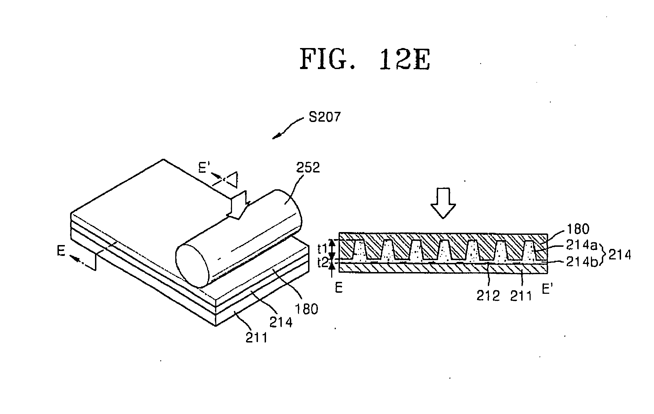

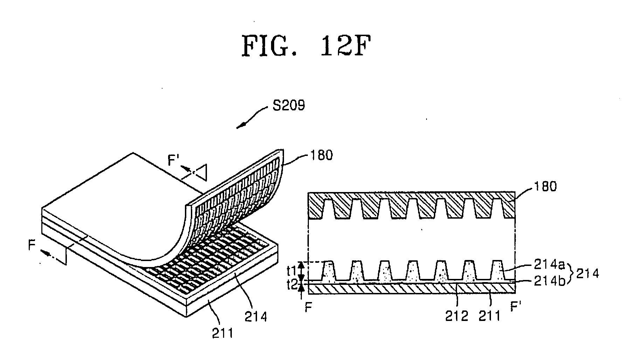

Thereafter, the dielectric sheet 214, which is patterned using the process described above, is forcibly brought into contact with a lower substrate 211 by applying pressure as will be described in more detail. Referring to FIG. 12D, the lower substrate 211 on which a plurality of electrodes 212 are disposed is prepared. Thereafter, the soft mold 180 and the dielectric sheet 214, which are bonded to each other under pressure, are disposed on the exposed electrodes 212 of the lower substrate 211. In this case, the unpatterned layer 214b of the dielectric sheet 214 is disposed opposite the exposed electrodes 212 of the lower substrate 211. Referring to FIG. 12E, a pressure roller 252 for applying a predetermined pressure is applied to the soft mold 180 at least once from one end of the soft mold 180 to the other end thereof at a uniform rotation rate, so that the lower substrate 211 is bonded to the dielectric sheet 214 under pressure. The bonding process is continued until at least the exposed electrodes 212 of the lower substrate 211 are sufficiently covered by the unpatterned layer 214b of the dielectric sheet 214 and the lower substrate 211 is reliably adhered to the dielectric sheet 214. Referring to FIG. 12F, the soft mold 180 is released. Finally, the resultant structure is sintered, thereby stabilizing the dielectric sheet 214 having a barrier rib pattern and the adhesion of the dielectric sheet 214 to the lower substrate 211.

According to the above-described method of manufacturing a lower panel of a PDP, a barrier rib pattern can be simply manufactured by applying pressure to the soft mold using a single transfer process, as compared with a conventional method that involves a series of complicated processes, specifically, coating barrier rib paste on a substrate, forming a pattern mask for the barrier rib paste, and performing an etching process. Thus, the present invention as defined in the claims provides a simple manufacturing process compared to the prior art. In addition, a barrier rib and a dielectric layer, which are conventionally formed using separate processes, are formed in a single process. The present embodiment provides a dielectric barrier rib including an unpatterned layer functioning as a dielectric layer to cover electrodes and a patterned layer functioning as a barrier rib to partition discharge spaces. The dielectric barrier rib can be formed using a single pressure-transfer process. Therefore, the method according to the present embodiment can greatly reduce the number of process operations.

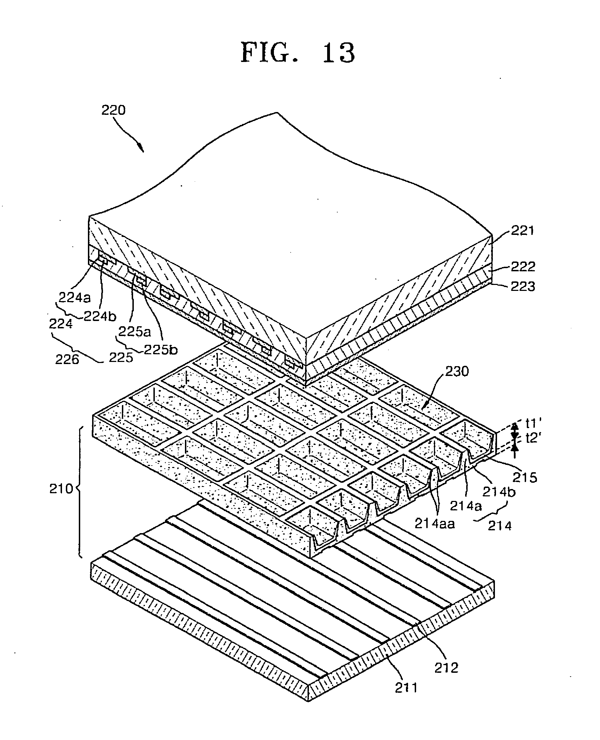

Hereinafter, a PDP manufactured according to the above-described method will be described with reference to FIG. 13. FIG. 13 is an exploded perspective view of a PDP according to an embodiment of the present invention Referring to FIG. 13, the PDP is largely divided into an upper panel 220 and a lower panel 210, which are bonded to each other. The upper panel 220 includes an upper substrate 221, a plurality of pairs of discharge sustain electrodes 226, and a dielectric layer 222 disposed on the upper substrate 221 to cover the pairs of discharge sustain electrodes 226. Meanwhile, the lower panel 210 includes a lower substrate 211, a plurality of address electrodes 212 disposed on the lower substrate 211, and a barrier rib layer 214 interposed between the upper substrate 221 and the lower substrate 211 to partition a plurality of discharge spaces 230.

The upper substrate 221 may be a display surface on which an image is projected. In this case, the upper substrate 221 may be a glass substrate having good optical transparency. Meanwhile, the lower substrate 211 also may be a glass substrate. However, in order to embody a flexible display, the upper and lower substrates 221 and 211 may be flexible plastic substrates having both optical transparency and flexibility.

The pairs of discharge sustain electrodes 226 disposed under the upper substrate 221 correspond to the discharge spaces 230, respectively. An alternating current (AC) signal with alternating sustain pulses is applied between the pairs of discharge sustain electrodes 226 to induce sustain discharge in the corresponding discharge spaces 230. Discharge sustain electrodes 224 and 225 include transparent electrodes 224a and 225a, respectively, which extend across a row of discharge spaces 230, and bus electrodes 224b and 225b, respectively, which contact the transparent electrodes 224a and 225a to supply driving power. However, the present invention is not limited to the above-described electrode structure.

The address electrodes 212 are disposed on the lower substrate 211 to cause address discharge along with the discharge sustain electrode 224 or 225. The address electrodes 212 may be arranged as stripes that extend at regular intervals parallel to one another and correspond to the respective discharge spaces 230.

The barrier rib layer 214 for partitioning the respective discharge spaces 230 as independent emission regions is disposed between the upper substrate 221 and the lower substrate 211 to prevent optical and electrical crosstalk. As described above, the barrier rib layer 214 is obtained by imprinting a soft mold (refer to 180 in FIG. 12F) having a barrier rib pattern to the barrier rib layer 214 (refer to 214 in FIG. 12F). Thus, a patterned layer 214a having a thickness t1', which is patterned due to the soft mold, and an unpatterned layer 214b having a thickness t2' are integrally formed in the barrier rib layer 214. The barrier rib layer 214 constitutes a dielectric barrier rib. That is, the patterned layer 214a may function as a barrier rib for partitioning the discharge spaces 230 between the upper and lower substrates 221 and 211, and the unpatterned layer 214b may function as a dielectric layer that covers the address electrodes 212.

The unpatterned layer 214b covers and protects the underlying address electrodes 212 and functions as a conventional dielectric layer that cuts off an electrical conduction path between the address electrodes 212. The unpatterned layer 214b that replaces the conventional dielectric layer may be formed to a sufficient thickness t2' to prevent the occurrence of an electrical breakdown.

Also, the patterned layer 214a may be formed as a closed type patterned layer to enclose all sides of the discharge spaces 230 or an open type patterned layer to open some sides of the discharge spaces 230 depending on the shape of the soft mold. For example, the closed-type patterned layer may be formed as a matrix type patterned layer with ribs intersecting each other to partition discharge spaces having square cross-sections. In addition, the closed-type patterned layer may partition polygonal discharge spaces, such as pentagonal or hexagonal discharge spaces, circular discharge spaces, or elliptical discharge spaces. Also, the open-type patterned layer may be embodied by stripe patterns, but the present invention is not limited thereto.

Meanwhile, pattern sides 214aa that contact the discharge spaces 230 are not the etched surfaces formed using a conventional dry etching process such as a sandblasting process or a wet etching process incorporating an etchant, but the pressed surfaces formed by pressing the soft mold 180 in a downward direction. Also, since a conventional barrier rib that is formed by filling a liquid photosensitive paste material in a mold and curing the paste material by light is not formed using a imprinting process according the present invention, the barrier rib formed using the liquid photosensitive paste material has sides different from the pattern sides 214aa according to the present invention. The pattern sides 214aa may be inclined at a predetermined angle considering the release of the barrier rib layer 214 from the soft mold 180. Meanwhile, the barrier rib layer 214 is bonded under pressure to the lower substrate 211 having the address electrodes 212. Thus, an interface between the barrier rib layer 214 and the lower substrate 211 forms a pressure bond surface.

A phosphor layer 215 is formed in a region corresponding to each of the discharge spaces 230. For example, the phosphor layer 215 can include red (R), green (G), and blue (B) phosphor layers, which emit red, green and blue light, respectively, and are alternately coated on the pattern sides 214aa, which contact the discharge spaces 230, and bottom surfaces of the discharge spaces 230. The respective discharge spaces 230 form R, G, and B sub-pixels according to the type of the phosphor layer 215, and one R sub-pixel , one G sub-pixel, and one B sub-pixel form a unit pixel. However, the type of the phosphor layer 215 coated in each of the discharge spaces 230 is not restricted to R, G, and B phosphor layers, and phosphor layers 215 having different colors may be additionally included to increase the color purity of an image.

Meanwhile, in the case of the barrier rib layer 214 according to an embodiment of the present invention, the patterned layer 214a functions as a barrier rib that partitions the discharge spaces 230, while the unpatterned layer 214b functions as a dielectric layer. The barrier rib layer 214 aids in shortening the manufacturing process, but the present invention is not limited thereto. For instance, in addition to the barrier rib layer 214, a dielectric layer (not shown) for covering the address electrodes 212 may be formed.

According to the present invention as described in the claims, a high-precision soft mold is provided in order to form a high-resolution barrier rib pattern. Thus, a precise barrier rib pattern can be formed using the soft mold.

Also, the present invention provides a method of manufacturing the barrier rib pattern by preparing a soft mold according to claim 1 and by imprinting the soft mold to a dielectric sheet for shaping a barrier rib. As compared with a conventional method, the manufacturing process according to the present invention is simple and convenient, and a pattern of the soft mold can be accurately transferred to the dielectric sheet.

In particular, a dielectric barrier rib, which functions not only as a dielectric layer for burying electrodes but also as a barrier rib for partitioning discharge spaces, can be formed using a single imprinting process. Therefore, the number of process operations can be greatly reduced, compared with a conventional method by which a dielectric layer and a barrier rib are formed using separate processes.

Furthermore, a PDP manufactured using the soft mold is provided. In the PDP, a barrier rib for partitioning respective discharge spaces as independent emission regions can be accurately formed. Thus, the barrier rib has improved performance, thereby enhancing the image quality of the PDP.

## Claims

1. A method of manufacturing a soft mold (180), comprising:
providing a metal mold (150) on which a barrier rib pattern with alternating concave portions and convex portions is formed;
disposing a polymer sheet (180') opposite the metal mold (150); **characterized by**
transferring the barrier rib pattern of the metal mold (150) by imprinting the metal mold (150) into the surface of the polymer sheet (180') under pressure such that the polymer sheet (180') has a surface on which an inverted image of the barrier rib pattern is formed to form the soft mold (180); and
releasing the soft mold (180) from the metal mold (150).

2. The method of claim 1, wherein the providing of the metal mold (150) comprises:
forming a photoresist (PR) pattern (115) having the shape of a barrier rib on a base substrate (100) having concave portions (111) and convex portions (112) (S101);
forming a silicon mold (130) having an inverted pattern conformable to the PR pattern (S103);
forming a metal seed layer (135) required for electroplating along a surface of the pattern of the silicon mold (130) (S105);
filling the pattern of the silicon mold (130) with an electroplating layer to form the metal mold (150) on the metal seed layer (135) (S107), and
releasing the silicon mold from the metal mold (S109).

3. The method of claim 2, wherein the forming of the PR pattern (115) comprises patterning a PR layer (110) using exposure and developing processes.

4. The method of claim 2, wherein the forming of the silicon mold (130) comprises coating a silicon shaping material to bury the PR pattern (115), and curing the silicon shaping material so that the silicon mold (130) to which the PR pattern (115) is transferred is obtained.

5. A method of manufacturing a barrier rib for a plasma display panel, the method comprising:
preparing a soft mold (180) for shaping a barrier rib according to claim 1, the mold (180) having a patterned surface (S201);
disposing a dielectric sheet (214) opposite the soft mold (180) (S203);
and
transferring a pattern of the soft mold (180) into the dielectric sheet (214) under pressure to shape a patterned layer (214a) to which pressure is applied and an unpatterned layer (214b) disposed on the reverse side of the patterned layer (214a) (S205).

6. The method of claim 5, wherein the barrier rib pattern comprises alternating concave portions (181) and convex portions (182).

7. The method of claim 5 or 6, wherein the unpatterned layer (214b) of the dielectric sheet (214) is formed to a sufficient thickness to incorporate electrodes.

8. A method of manufacturing a lower panel of a plasma display panel, the method comprising:
preparing a soft mold (180) for shaping a barrier rib according to claim 1, the mold (180) having a patterned surface (S201);
disposing a dielectric sheet (214) opposite the mold (180) (S203);
transferring a pattern of the soft mold (180) onto the dielectric sheet (214) under pressure to shape the dielectric sheet (214) to have a patterned layer (214a) having a first thickness (t1) and an unpatterned layer (214b) having a second thickness (t2) (S205);
disposing the unpatterned layer (214b) of the dielectric sheet (214) opposite a plurality of exposed electrodes (212) of a substrate (211); and
bonding the dielectric sheet (214) to the substrate (211) under pressure (S207).

9. The method of claim 8, wherein the barrier rib pattern comprises alternating concave portions (181) and convex portions (182).

10. The method of claim 8 or 9, further comprising vertically aligning the mold (180) bonded to the dielectric sheet (214) with the electrodes (212) of the substrate (211) after disposing the unpatterned layer (214b) and before bonding the dielectric sheet (214) to the substrate (211) under pressure.

11. The method of one of the claims 8 to 10, wherein, in the bonding of the dielectric sheet (214) to the substrate (211) under pressure, the unpatterned layer (214b) of the dielectric sheet (214) buries the electrodes (212) of the substrate (211).

12. The method of one of the claims 8 to 11, after the bonding of the dielectric sheet (214) to the substrate (211) under pressure, further comprising the step of
releasing the soft mold (S209), and
sintering the dielectric sheet (214) and the substrate (211) that are bonded to each other (S211).

## Patentansprüche

1. Verfahren zur Herstellung einer weichen Gussform (180), aufweisend:
Bereitstellen einer Metallgussform (150), auf der ein Sperrrippenmuster mit abwechselnden konkaven Abschnitten und konvexen Abschnitten ausgebildet ist;
Anordnen einer Polymerlage (180') gegenüber der Metallgussform (150); **gekennzeichnet durch**
Übertragen des Sperrrippenmusters der Metallgussform (150) **durch** Prägen der Metallgussform (150) in die Oberfläche der Polymerlage (180') unter Druck, so dass die Polymerlage (180') eine Oberfläche aufweist, auf der ein Kehrbild des Sperrrippenmusters ausgebildet ist, um die weiche Gussform (180) zu bilden;
und
Lösen der weichen Gussform (180) aus der Metallgussform (150).

2. Verfahren nach Anspruch 1, wobei das Bereitstellen der Metallgussform (150) aufweist:
Bilden eines Photoresist- (PR)-Musters (115), das die Gussform einer Sperrrippe aufweist, auf einem Grundsubstrat (100), das konkave Abschnitte (111) und konvexe Abschnitte (112) aufweist (S101);
Bilden einer Siliziumgussform (130), die ein invertiertes Muster aufweist, das dem PR-Muster entspricht (S103);
Bilden einer Metallkeimschicht (135), die zum Galvanisieren längs einer Oberfläche des Musters der Siliziumgussform (130) benötigt wird (S105);
Füllen des Musters der Siliziumgussform (130) mit einer Galvanisierungsschicht, um die Metallgussform (150) auf der Metallkeimschicht (135) zu bilden (S107), und
Lösen der Siliziumgussform aus der Metallgussform (S109).

3. Verfahren nach Anspruch 2, wobei das Bilden des PR-Musters (115) das Mustern einer PR-Schicht (110) mittels Belichtungs- und Entwicklungsprozessen aufweist.

4. Verfahren nach Anspruch 2, wobei das Bilden der Siliziumgussform (130) das Beschichten eines Siliziumformungsmaterials, um das PR-Muster (115) zu bedecken, und das Härten des Siliziumformungsmaterials aufweist, so dass die Siliziumgussform (130) erhalten wird, auf die das PR-Muster (115) übertragen ist.

5. Verfahren zur Herstellung einer Sperrrippe für eine Plasmaanzeigetafel, wobei das Verfahren aufweist:
Vorbereiten einer weichen Gussform (180) zur Ausbildung einer Sperrrippe nach Anspruch 1, wobei die Gussform (180) eine gemusterte Oberfläche aufweist (S201);
Anordnen einer dielektrischen Lage (214) gegenüber der weichen Gussform (180) (S203); und
Übertragen eines Musters der weichen Gussform (180) in die dielektrischen Lage (214) unter Druck, um eine gemusterte Schicht (214a), auf die Druck ausgeübt wird, und eine ungemusterte Schicht (214b) zu bilden, die auf der Rückseite der gemusterten Schicht (214a) angeordnet ist (S205).

6. Verfahren nach Anspruch 5, wobei das Sperrrippenmuster abwechselnde konkave Abschnitte (181) und konvexe Abschnitte (182) aufweist.

7. Verfahren nach Anspruch 5 oder 6, wobei die ungemusterte Schicht (214b) der dielektrischen Lage (214) in einer ausreichenden Dicke gebildet wird, um Elektroden einzubauen.

8. Verfahren zur Herstellung einer unteren Tafel einer Plasmaanzeigetafel, wobei das Verfahren aufweist:
Vorbereiten einer weichen Gussform (180) zur Ausbildung einer Sperrrippe nach Anspruch 1, wobei die Gussform (180) eine gemusterte Oberfläche aufweist (S201);
Anordnen einer dielektrischen Lage (214) gegenüber der Gussform (180) (S203);
Übertragen eines Musters der weichen Gussform (180) auf die dielektrische Lage (214) unter Druck, um die dielektrische Lage (214) so zu bilden, dass sie eine gemusterte Schicht (214a) mit einer ersten Dicke (t1) und eine ungemusterte Schicht (214b) mit einer zweiten Dicke (t2) aufweist (S205);
Anordnen der ungemusterten Schicht (214b) der dielektrischen Lage (214) gegenüber mehreren freiliegenden Elektroden (212) eines Substrats (211); und
Binden der dielektrischen Lage (214) an das Substrat (211) unter Druck (S207).

9. Verfahren nach Anspruch 8, wobei das Sperrrippenmuster abwechselnde konkave Abschnitte (181) und konvexe Abschnitte (182) aufweist.

10. Verfahren nach Anspruch 8 oder 9, das ferner das vertikale Ausrichten der an die dielektrische Lage (214) gebundenen Gussform (180) mit den Elektroden (212) des Substrats (211) nach dem Anordnen der ungemusterten Schicht (214b) und vor dem Binden der dielektrischen Lage (214) an das Substrat (211) unter Druck aufweist.

11. Verfahren nach einem der Ansprüche 8 bis 10, wobei beim Binden der dielektrischen Lage (214) an das Substrat (211) unter Druck die ungemusterte Schicht (214b) der dielektrischen Lage (214) die Elektroden (212) des Substrats (211) bedeckt.

12. Verfahren nach einem der Ansprüche 8 bis 11, das nach dem Binden der dielektrischen Lage (214) an das Substrat (211) unter Druck ferner den Schritt aufweist
Lösen der weichen Gussform (S209), und
Sintern der dielektrischen Lage (214) und des Substrats (211), die aneinander gebunden sind (S211).

## Revendications

1. Procédé de fabrication d'un moule souple (180), comprenant les étapes consistant à :
fournir un moule métallique (150) sur lequel est formé un motif de nervure barrière présentant des parties concaves et convexes alternées ;
disposer une feuille polymère (180') en regard du moule métallique (150) ; **caractérisé par** le fait de :
transférer le motif de nervure barrière du moule métallique (150) par empreinte sous pression du moule métallique (150) dans la surface de la feuille polymère (180') de manière que la feuille polymère (180') possède une surface sur laquelle est formée une image inversée du motif de nervure barrière afin de former le moule souple (180) ; et
extraire le moule souple (180) du moule métallique (150).

2. Procédé selon la revendication 1, dans lequel la fourniture du moule métallique (150) comprend les étapes consistant à :
former un motif de photorésine (PR) (115) ayant la forme d'une nervure barrière sur un substrat de base (100) présentant des parties concaves (111) et des parties convexes (112) (S101) ;
former un moule de silicone (130) ayant un motif inversé apte à épouser le motif (PR) (S103) ;
former une couche de germes de métal (135) requise pour galvanoplastie le long d'une surface du motif du moule de silicone (130) (S105) ;
remplir le motif du moule de silicone (130) d'une couche de galvanoplastie pour former le moule métallique (150) sur la couche de germes de métal (135) (S107), et
extraire le moule de silicone (130) du moule métallique (S109).

3. Procédé selon la revendication 2, dans lequel la formation du motif PR (115) comprend la création d'un motif dans une couche PR (110) par utilisation de procédés d'exposition et de développement.

4. Procédé selon la revendication 2, dans lequel la formation du moule de silicone (130) comprend le revêtement d'un matériau de façonnage de silicone pour enfouir le motif PR (115), et le durcissement du matériau de façonnage de silicone de manière que soit obtenu le moule de silicone (130) auquel est transféré le motif PR (115).

5. Procédé de fabrication d'une nervure barrière pour écran plasma, le procédé comprenant les étapes consistant à :
préparer un moule souple (180) pour façonner une nervure barrière selon la revendication 1, le moule (180) présentant une surface à motif (S201) ;
disposer une feuille diélectrique (214) en regard du moule souple (180) (S203) ; et
transférer sous pression un motif du moule souple (180) dans la feuille diélectrique (214) afin de façonner une couche à motif (214a) à laquelle est appliquée une pression et une couche sans motif (214b) disposée au verso de la couche à motif (214a) (S205).

6. Procédé selon la revendication 5, dans lequel le motif de nervure barrière comprend des parties concaves (181) et des parties convexes (182) alternées.

7. Procédé selon la revendication 5 ou 6, dans lequel la couche sans motif (214b) de la feuille diélectrique (214) est formée avec une épaisseur suffisante pour pouvoir loger des électrodes.

8. Procédé de fabrication d'un panneau inférieur d'un écran plasma, le procédé comprenant les étapes consistant à :
préparer un moule souple (180) pour façonner une nervure barrière selon la revendication 1, le moule (180) comportant une surface à motif (S201);
disposer une feuille diélectrique (214) en regard du moule (180) (S203) ;
transférer sous pression un motif du moule souple (180) sur la feuille diélectrique (214) pour que la feuille diélectrique (214) comporte une couche à motif (214a) ayant une première épaisseur (214a) et une couche sans motif (214b) ayant une seconde épaisseur (t2) (S205) ;
disposer la couche sans motif (214b) de la feuille diélectrique (214) en regard d'une pluralité d'électrodes exposées (212) d'un substrat (211) ; et
lier sous pression (S207) la feuille diélectrique (214) au substrat (211).

9. Procédé selon la revendication 8, dans lequel le motif de nervure barrière comprend des parties concaves (181) et des parties convexes (182) alternées.

10. Procédé selon la revendication 8 ou 9, comprenant, en outre, l'alignement vertical du moule (180) lié à la feuille diélectrique (214) avec les électrodes (212) du substrat (211) après avoir disposé la couche sans motif (214b) et avant d'avoir lié sous pression la feuille diélectrique (214) au substrat (211).

11. Procédé selon l'une des revendications 8 à 10, dans lequel, lors de la liaison sous pression de la feuille diélectrique (214) au substrat (211) la couche sans motif (214b) de la feuille diélectrique (214) enfouit les électrodes (212) du substrat (211).

12. Procédé selon l'une des revendications 8 à 11, après la liaison sous pression de la feuille diélectrique (214) au substrat (211), comprenant en outre les étapes consistant à :
extraire le moule souple (S209), et
fritter la feuille diélectrique (214) et le substrat (211) qui sont liés l'un à l'autre (S211).
